# EUROPEAN PATENT APPLICATION

(11) **EP 0 675 542 A2**
(43) Date of publication of application: **04.10.1995**
(21) Application number: 95104066.6
(22) Date of filing: 20.03.1995
(51) Int. Cl.: H01L 27/02

(54) **Semiconductor device having digital and analog circuits**

(30) Priority: 31.03.1994 JP 64040/94
(71) Applicant: FUJITSU LIMITED, Kawasaki-shi, Kanagawa 211 (JP)
(72) Inventor: Nonaka, Kazuyuki, c/o Fujitsu VLSI Limited, Kasugai-shi, Aichi, 487 (JP); Sumi, Hideji, c/o Fujitsu VLSI Limited, Kasugai-shi, Aichi, 487 (JP)
(74) Representative: Stebbing, Timothy Charles

(57) **Abstract**

A semiconductor device (1) having a digital circuit section (2) and an analog circuit section (3) provided on a semiconductor substrate. A pattern area (4) is provided between the digital and analog circuit sections, to separate the circuit sections from each other by a preset distance. The pattern area includes a plurality of patterns used in fabrication of the device, and is electrically isolated from the digital and analog circuit sections.

## Description

The present invention relates generally to a semiconductor device, and in particular to a semiconductor device having digital and analog circuit sections formed on the same semiconductor substrate.

In the field of integrated semiconductor technology, the need for smaller circuitry with increased multifunctionality has resulted in the design of circuits having both analog and digital circuitry on the same semiconductor chip. The analog section of such dual purpose chips may contain, for example, a linear signal amplifier, an analog filter or a voltage-controlled oscillator. The digital section frequently contains a logic circuit and operates concurrent with the operation of the analog section.

Since the analog and digital circuitry can be integrated on one semiconductor substrate, the size of the semiconductor device can be significantly reduced. Moreover, such chips exhibit enhanced multi functionality. The formation of the analog and digital circuit sections on the same substrate may unfortunately allow switching noise generated in the digital circuit section to affect the analog circuit section. It is consequently necessary to isolate the analog circuit section from switching noise .

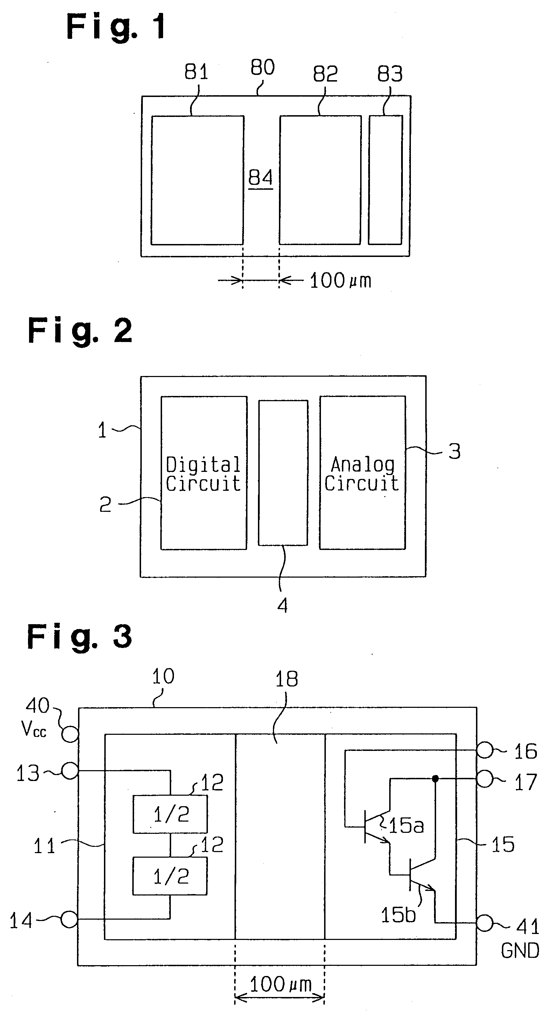

Fig. 1 illustrates the schematic circuit layout of a conventional analog/digital semiconductor device. A digital circuit section 81 and an analog circuit section 82 are arranged on a semiconductor substrate 80 with an isolation area 84 separating the analog and digital sections. The width of the isolation area 84 is set to, for example, about 100 micrometers in order to prevent interference from occurring between the digital and analog circuit sections 81 and 82. The isolation area 84 thus acts to isolate and protect the analog circuit section 82 from the switching noise produced in the digital circuit section 81.

The semiconductor substrate 80 is further provided with a pattern area 83 which has a variety of patterns utilized during a fabrication process, such as a mask positioning pattern, monitoring pattern for checking characteristics, diffusion monitoring pattern, and etching monitoring pattern. One consequence of using an isolation area 84 and a pattern area 83, however, is that the overall size of the semiconductor device on which the patterns are formed increases. The increase in chip size therefore decreases the yield and increases the manufacturing cost of the semiconductor device.

An embodiment of the present invention can provide a semiconductor device incorporating analog and digital circuitry, which is smaller than conventional analog/digital devices and which allows for increased manufacturing yields and for reduced manufacturing costs.

As shown in Fig. 2, a semiconductor device according to the present invention has a digital circuit section 2 and an analog circuit section 3 spaced apart from each other by a predetermined interval, on a semiconductor substrate 1. The digital circuit section 2 generally handles digital signals, while the analog circuit section 3 generally handles analog signals. A pattern area 4 is provided between the digital circuit section 2 and the analog circuit section 3, and contains various patterns necessary for the fabrication process of the semiconductor device. The digital and analog circuit sections 2 and 3 function independent of the various patterns.

Reference is made, by way of example, to the accompanying drawings in which:
Fig. 1 is a schematic circuit layout diagram of a conventional semiconductor device incorporating analog and digital circuitry;
Fig. 2 is a schematic circuit layout diagram of a semiconductor device according to the present invention;
Fig. 3 is a circuit diagram illustrating the layout of a semiconductor device according to one embodiment of the present invention;
Fig. 4 is a pattern diagram used for device-characteristic monitoring and for probing test pads;
Fig. 5 is a circuit diagram of a ring oscillator;
Fig. 6 illustrates mask positioning patterns;
Fig. 7 illustrates a pattern used in monitoring the etching process during the formation of the semiconductor device according to the present invention;
Fig. 8 illustrates an exposure size measuring pattern;
Fig. 9 illustrates diagram of a marking pad;
Fig. 10 is a pattern diagram of a mask identifying character pattern;
Fig. 11 illustrates the layout of a circuit diagram of another embodiment according to the present invention;
Fig. 12 is an enlarged view showing an amplifying circuit incorporated in Fig. 11;
Fig. 13 is an enlarged view showing a mask positioning pattern incorporated in Fig. 11;
Fig. 14 is an enlarged view of portions of the circuit shown in Fig. 11 designed for device-characteristic monitoring and for test probing pads;
Fig. 15 is an enlarged view illustrating a ring oscillator incorporated in Fig. 11;
Fig. 16 is a block diagram showing a Phase Locked Loop (PLL) synthesizer.

A semiconductor device for communications equipment, as an embodiment of the present invention, will now be described with reference to Figs. 3 through 10.

As shown in Fig. 3, a prescaler 11 in a digital circuit section and an amplifying circuit 15 in an analog circuit are formed, separated by a predetermined distance on an N type semiconductor substrate 10. A portion of the area between the prescaler 11 and the amplifying circuit 15 is used as a pattern area 18.

The prescaler 11 includes two series-connected frequency-dividing circuits 12, each of which divides the frequency of an input signal by one half. Accordingly, the prescaler 11 divides the frequency of a clock signal as a digital signal, input via an input terminal 13, to one fourth, and outputs the frequency-divided signal to an output terminal 14. Power source terminal 40 and ground terminal 41 are provided at the periphery of the semiconductor substrate 10. The semiconductor device is supplied with an operation supply voltage V_{CC} via the terminal 40.

The amplifying circuit 15 has two bipolar transistors 15a and 15b forming a Darlington circuit, and is connected to an input terminal 16, an output terminal 17 and the ground (GND) terminal 41.

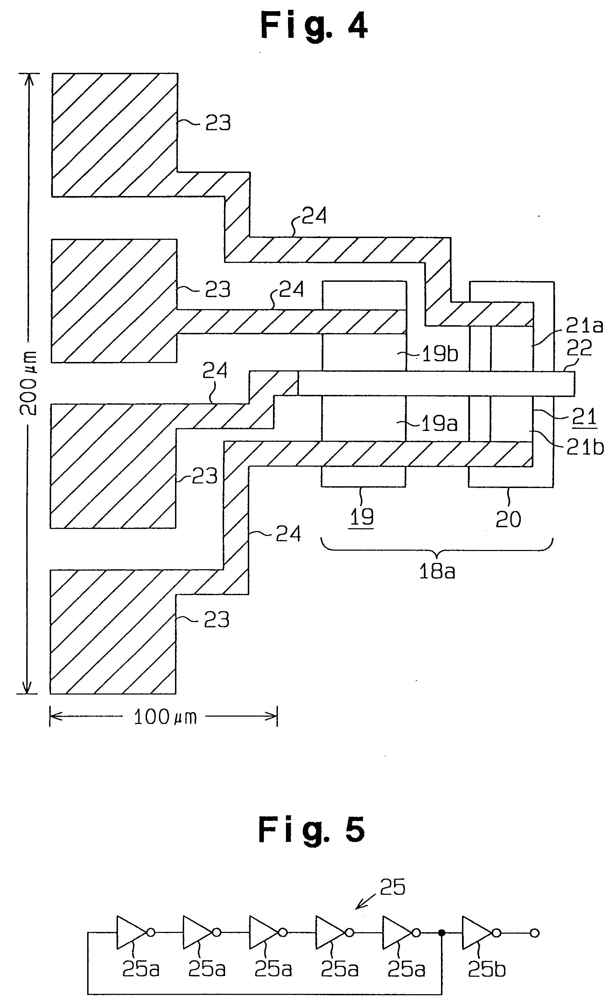

A variety of patterns, which are irrelevant to semiconductor device operation but are necessary for the device's fabrication, are formed and left in the pattern area 18. Types of the patterns disposed in the area 18 will be described below with reference to Figs. 4 to 10.

Fig. 4 shows patterns for a device-characteristic monitoring element and probing test pads. A device-characteristic monitoring element 18a comprises a P channel type MOS (PMOS) transistor 19 and an N channel type MOS (NMOS) transistor 21. The PMOS transistor 19 comprises P type diffusion sections 19a and 19b each formed in a rectangular shape on the N type semiconductor substrate 10, and a gate section 22, made of polysilicon, passing above the intermediate portion of both diffusion sections 19a and 19b. The NMOS transistor 21 comprises N type diffusion sections 21a and 21b formed in a P well 20 in the N type semiconductor substrate 10, as illustrated in Fig.3. The gate section 22, as shown in Fig.4, passes above the intermediate portion of both diffusion sections 21a and 21b.

A plurality of probing test pads 23 are disposed adjacent to the device-characteristic monitoring element 18a. The pads 23 are connected to the P type diffusion sections 19a and 19b, the N type diffusion sections 21a and 21b and the gate section 22 via aluminum wires 24. In this embodiment, the overall size of the pattern defined by the pads 23 and a portion of the device-characteristic monitoring element 18a is set to approximately 200 micrometers in the vertical direction. The pads 23 extend approximately 100 micrometers in the horizontal direction.

The device-characteristic monitoring element 18a is used as a diffusion monitor to check the diffusion of dopant during preparation of the wafer. After a wafer is formed, test probes abutting the pads 23, measure the breakdown voltage of P/N junction or the current amplification factor (h_{FE}) of the transistors 19 and 21. The quality of the wafer depends on the results of the voltage test. The monitoring element 18a is used only for the management of device characteristics. The element 18a does not contribute to the semiconductor device's functionality after the device's manufacture.

Fig. 5 shows a ring oscillator 25 formed in the pattern area 18. The ring oscillator 25 has an odd number of inverters 25a connected in series. The oscillation frequency is determined by the delay times of inverters 25a. Another inverter 25b is connected to the last stage of the ring oscillator 25, and functions to stabilize the oscillation of the ring oscillator 25. Each of the inverters 25a and 25b comprises a pair of PMOS and NMOS transistors similar to the PMOS and NMOS transistors 19 and 21.

The design of the ring oscillator 25 depends on the number and type of elements forming the prescaler 11. The gate switching speed of the elements forming the prescaler 11 can be indirectly detected by reference to the oscillation frequency of the oscillator 25. Likewise, the characteristic of the prescaler 11 can be also detected.

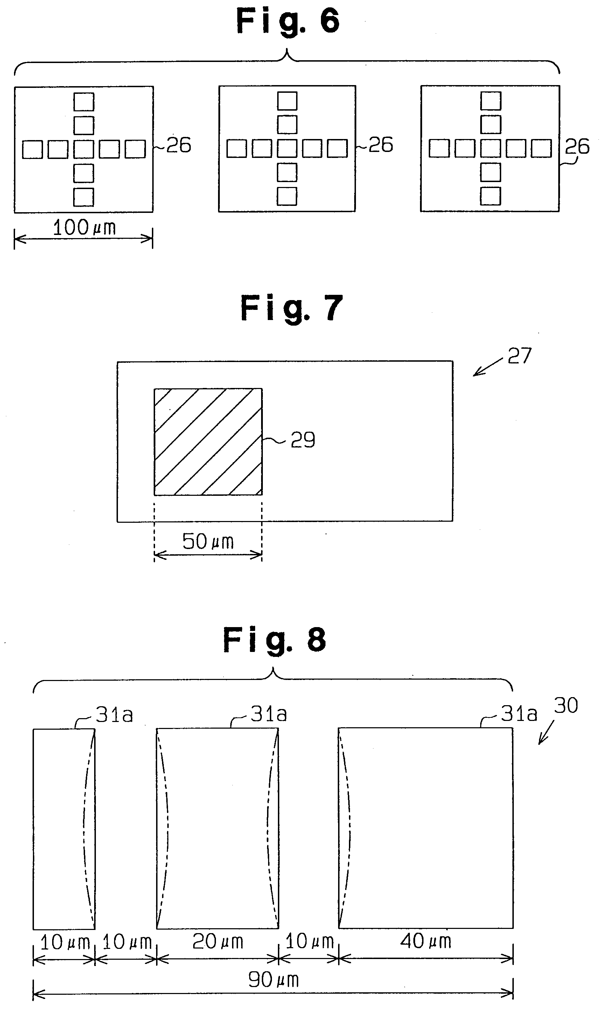

Fig. 6 illustrates the mask positioning patterns 26 as marks on the substrate 10. The positioning patterns 26 are used at the time when the position of a photomask used in a wafer manufacturing process, is adjusted to conform to a particular wafer design. Each of the mask positioning patterns 26 is square, and has sides that measure about 100 micrometers in length. Two to ten patterns 26 are previously arranged on the substrate 10 in accordance with the number of photomasks used during the manufacturing process.

Fig. 7 illustrates an etch monitoring pattern 27, which is used to detect the etched depth of the semiconductor's insulation layer during the etching process. Following the semiconductor device's formation, the monitoring pattern 27 is left as a square electrode head 29 measuring approximately 50 micrometers in length on each of four sides. The head 29 exposes the top surface of a diffusion resistive section (not shown), in the pattern area 18 on the substrate 10. The number of patterns 27, arranged in the pattern area 18, is a function of the number of times the substrate was etched during the semiconductor's formation.

Fig. 8 shows a size measuring pattern 30, which is used to check or evaluate the precision of etching carried out during the semiconductor device manufacturing process. The size measuring pattern 30 comprises polysilicon electrodes 31a, 31b and 31c for MOS gates, which have widths of 10, 20 and 40 micrometers, respectively. The individual electrodes 31a, 31b and 31c are formed at intervals of 10 micrometers. In the resist etching process, for example, over-etching may occur on the electrodes 31a, 31b and 31c as indicated by alternate two short and long dashed lines. By observing the sides of the over etched and curved electrodes, it is possible to measure the resist width and adjust the etching time.

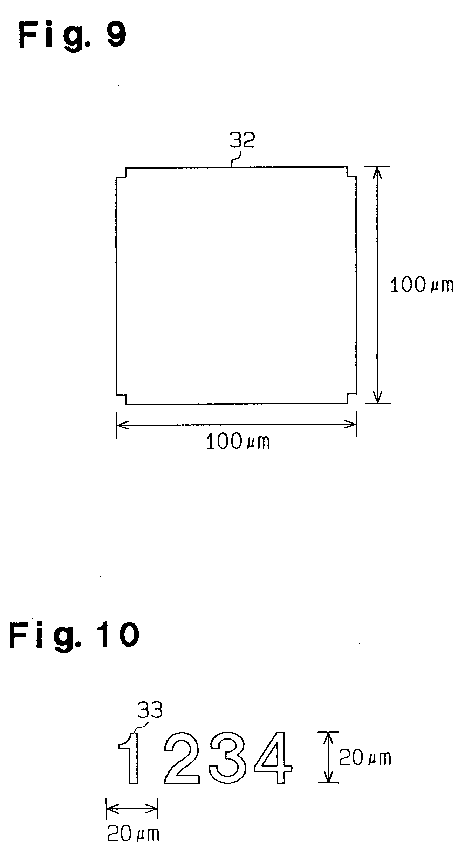

Fig. 9 shows an aluminum marking pad 32 having an approximately square shape with sides of about 100 micrometers in length. When a semiconductor chip on which the marking pad 32 is provided is defective, the pad 32 is scratched by a needle or the like, in order to distinguish the defective chip from good chips.

Fig. 10 shows mask number identifying character patterns 33. Each character pattern 33 has a size of about 20 micrometers vertically and horizontally. In general, an exposure reticle mask is machine set to a predetermined position. By comparing the character patterns 33 with the mask number, selection of the proper exposure mask can be checked.

With this semiconductor device, the output terminal 14 of the prescaler 11 and the input terminal 16 of the amplifying circuit 15 are connected by an external interconnection (not shown), e.g., an interconnection on the mounted substrate. When a clock signal of 1 GHz, for example, is input to the input terminal 13 of the prescaler 11, a signal of 250 MHz, due to frequency dividing, is output from the output terminal 14. The output signal is input to the amplifying circuit 15 via the external interconnection and the input terminal 16. The input signal is amplified, and is then sent to, for example, a PLL circuit (not shown) from the output terminal 17. Noise , produced in the activated prescaler 11, does not influence the signals of the amplifying circuit 15, due to the distance of 100 micrometers between the prescaler 11 and the amplifying circuit 15.

According to this embodiment, as described above in detail, the area between the prescaler 11 and the amplifying circuit 15 is used as the pattern area 18, in which various patterns, irrelevant to the operation of the semiconductor device and necessary in the fabrication of the semiconductor device, are formed. This reduces the size of the semiconductor substrate 10, improves the semiconductor device yield and reduces its manufacturing cost.

Since the prescaler 11 and the amplifying circuit 15 are separated by the pattern area 18, the influence of switching noise produced in the prescaler 11 on the amplifying circuit 15 can effectively be suppressed.

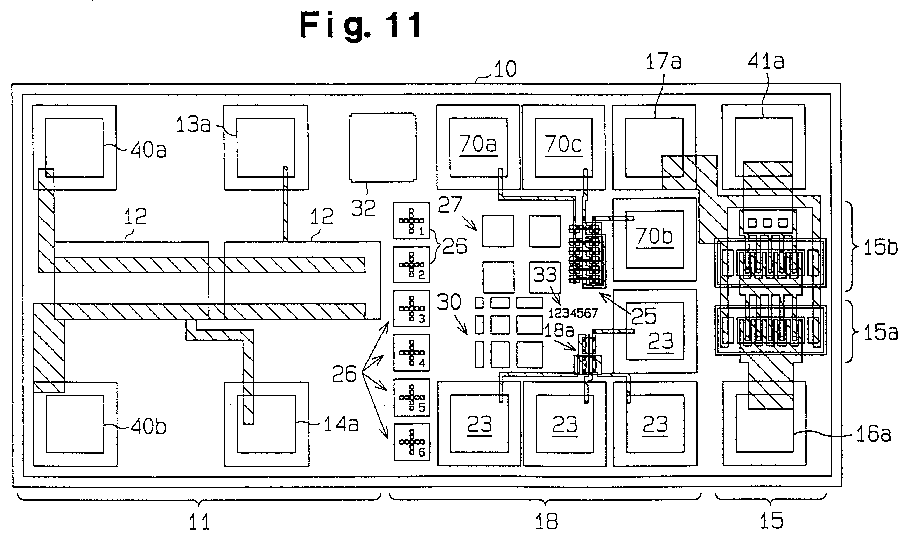

An example of a PLL synthesizer to which the present invention is applied will be described with reference to Figs. 11 through 16. In the following description, same reference numerals will be given to elements similar to those in the above-described embodiment, in order to avoid repeating the same descriptions.

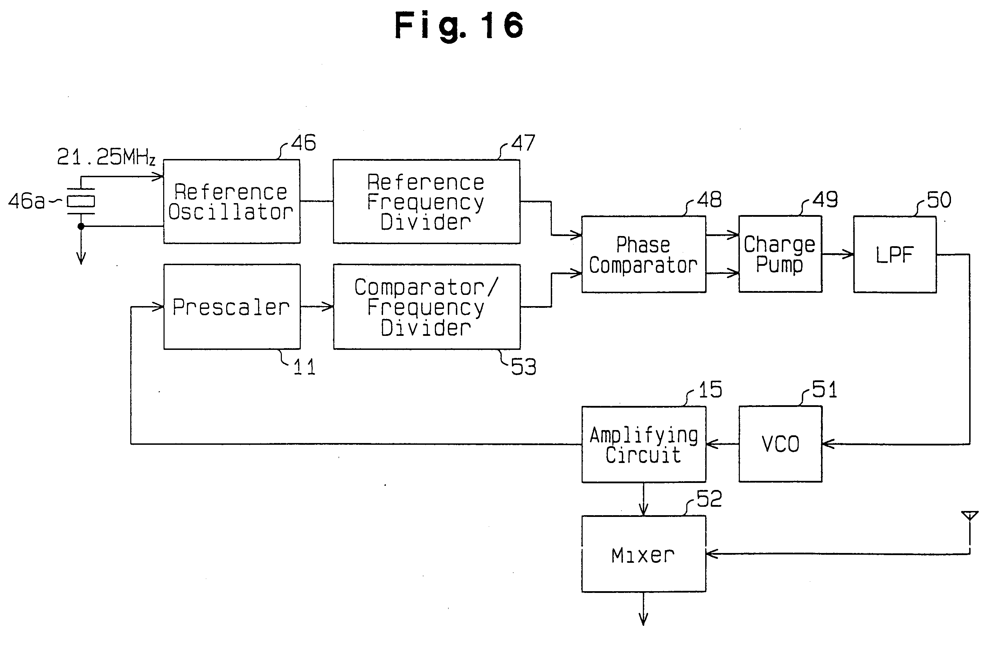

As shown in Fig. 16, a PLL synthesizer comprises a reference oscillator 46, a reference frequency divider 47, a phase comparator 48, a charge pump 49, a low-pass filter (hereinafter simply called LPF) 50, a voltage-controlled oscillator (hereinafter simply called VCO) 51, an amplifying circuit 15, a mixer 52, a prescaler 11, and a comparator/frequency divider 53.

A signal oscillating at a stable and predetermined frequency, is output from the crystal oscillator 46a to the reference oscillator 46, and from there to the reference frequency divider 47 where the oscillating signal is divided to a reference frequency. The divided signal is then provided as a reference signal to the phase comparator 48.

A frequency signal output from the VCO 51 is input to the prescaler 11 by way of the amplifying circuit 15. The prescaler 11 divides the frequency of the frequency signal by a predetermined integer, e.g. M+1, where M is a positive integer. The frequency divided output signal of the prescaler 11, is further divided by the comparator/frequency divider 53, based on a set frequency. This signal is then provided as a comparison signal to the phase comparator 48.

The phase comparator 48 compares the phase of the reference signal with that of the comparison signal and accordingly outputs a phase difference signal to the charge pump 49. The state of the charge pump's relative charge or discharge depends on the phase difference signal. The output of the charge pump 49 is smoothed by the LPF 50 and is output as a control voltage signal to the VCO 51.

The VCO 51 generates a frequency signal at a frequency corresponding to the voltage level of the control voltage signal from the LPF 50. This frequency signal is fed back to the prescaler 11. Due to this signal feed back processing, the frequency signal of the VCO 51 is finally locked to a multiple of the reference signal frequency.

As shown in Fig. 11, the prescaler 11 as a digital circuit section is provided on the left side of an N type semiconductor substrate 10. The prescaler 11 is composed of two frequency-dividing circuits 12 connected in series. A pad 40a for a high potential power supply V_{CC} and a pad 40b for a low potential power supply V_{SS} are formed on the end portion of the substrate 10. These power supply pads 40a and 40b are connected to the frequency-dividing circuits 12. Additionally, an input terminal pad 13a and an output terminal pad 14a for the prescaler 11 are formed on the substrate 10, and are connected to the frequency-dividing circuits 12.

The amplifying circuit 15, which amplifies the oscillation signal of the voltage-controlled oscillator (VCO), is formed as an analog circuit section on the right side of the substrate 10. The reference oscillator 46, reference frequency divider 47, phase comparator 48, charge pump 49, LPF 50, VCO 51, mixer 52 and comparator/frequency divider 53, are arranged on another semiconductor device or substrate (not shown). The prescaler 11 and amplifying circuit 15 comprise the analog section of the substrate 10.

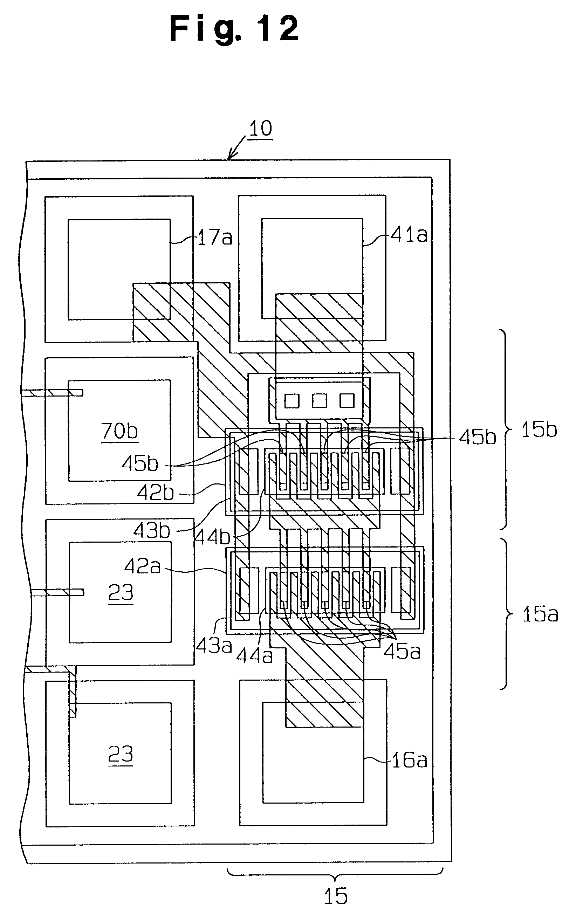

As shown in Fig. 12, the amplifying circuit 15 is formed with two bipolar transistors 15a and 15b. The transistors 15a and 15b are N type collector regions 43a and 43b and are isolated from the P type area by isolation regions 42a and 42b respectively. The P type regions 44a and 44b are disposed in the collector regions 43a and 43b, and the N type emitter regions 45a and 45b are formed in the base regions 44a and 44b.

The transistor 15a has a base 44a connected to the input terminal pad 16a, which is located at the lower right end of the substrate 10. The transistor 15b has an emitter 45b connected to a ground terminal pad 41a, which is located at the upper right end. The collectors 43a and 43b of the transistors 15a and 15b are connected to an output terminal pad 17a adjacent to the ground terminal pad 41a. The transistors 15a and 15b, as connected, form a Darlington circuit.

The prescaler 11 and amplifying circuit 15 are spaced apart, as shown in Fig. 11, by, for example, 300 micrometers. The area between the prescaler 11 and circuit 15 serves as a pattern area 18. Three probing test pads 23 are formed in line at the bottom portion of the pattern area 18, adjacent to the input terminal pad 16a. A further probing test pad 23 is formed adjacent to the transistor 15a. A device-characteristic monitoring element 18a is formed close to the four probing test pads 23.

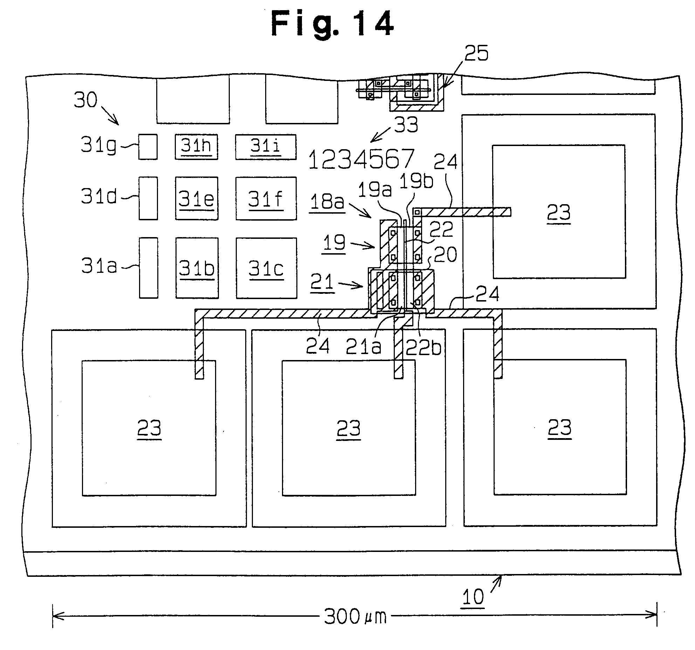

As shown in Fig. 14, the device-characteristic monitoring element 18a is composed of a PMOS transistor 19 and an NMOS transistor 21. The PMOS transistor 19 comprises P type diffusion sections 19a and 19b, each formed in a rectangular shape on the N type semiconductor substrate 10. A polysilicon gate section 22 of the PMOS transistor 19 passes above the intermediate portion between the diffusion sections 19a and 19b. The NMOS transistor 21 comprises N type diffusion sections 21a and 21b formed in a P well 20 in the N type semiconductor substrate 10. A gate section 22 of the NMOS transistor 21 passes above the intermediate portion between the N type diffusion sections 21a and 21b. The P type diffusion sections 19a and 19b, the N type diffusion sections 21a and 21b and the gate section 22 are respectively connected to the pads 23 by aluminum wires 24. In this embodiment, the whole length of the three pads 23 laterally arranged is set to about 300 micrometers.

As shown in Fig. 11, three pads 70a, 70b and 70c are formed in the pattern area 18, adjacent to the output terminal pad 17a at the upper portion of the substrate 10. A ring oscillator 25, close to pads 70a to 70c, is provided to create the desired frequency characteristics of the oscillating signal.

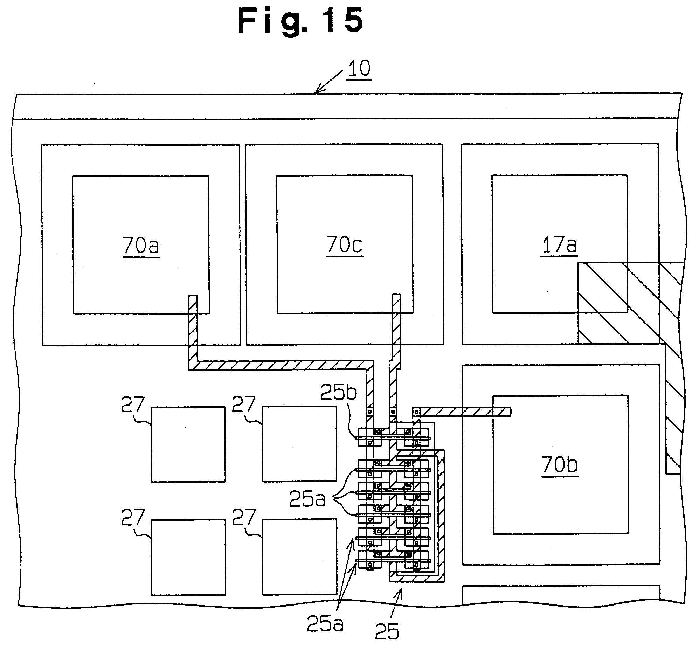

As shown in Fig. 15, the ring oscillator 25 has five inverters 25a connected in series. The oscillation frequency is determined by the delay times of the inverters 25a. A sixth inverter 25b is connected to the output of the last inverter 25a in order to stabilize the oscillation of the ring oscillator 25.

Each of the inverters 25a and 25b comprises PMOS and NMOS transistors similar to the PMOS transistor 19 and the NMOS transistor 21. The sources of the PMOS transistors for inverters 25a and 25b receive supply voltage V_{CC} from the pad 70a via aluminum wires. The sources of the NMOS transistors of the inverters 25a and 25b are grounded by the pad 70b via aluminum wires. The output terminal of the sixth inverter 25b is connected to the pad 70c via an aluminum wire.

Further, as shown in Fig. 15, four square shaped etching monitoring patterns 27, the sides of which measure about 50 micrometers in length, are disposed below the pads 70a and 70c. As shown in Fig. 14, a mask number identifying character pattern 33 is formed in the area between the ring oscillator 25 and the device-characteristic monitoring element 18a.

Further, as shown in Fig. 14, a size measuring pattern 30 is disposed above the pads 23. The size measuring pattern 30 comprises nine types of polysilicon electrodes 31a to 31i for MOS gates. The electrodes 31a, 31d and 31g each have a width of 10 micrometers. The electrodes 31b, 31e and 31h each have a width of 20 micrometers. The electrodes 31c, 31f and 31i have a width of 40 micrometers. The electrodes 31a, 31b and 31c each have a height of 40 micrometers. The electrodes 31d, 31e and 31f each have a height of 20 micrometers. The electrodes 31g, 31h and 31i each have a height of 10 micrometers. The individual electrodes 31a to 31i are positioned apart from the adjoining ones at intervals of 10 microns.

The character pattern 33, adjacent to the size measuring pattern 30, has a size of 20 micrometers vertically and horizontally.

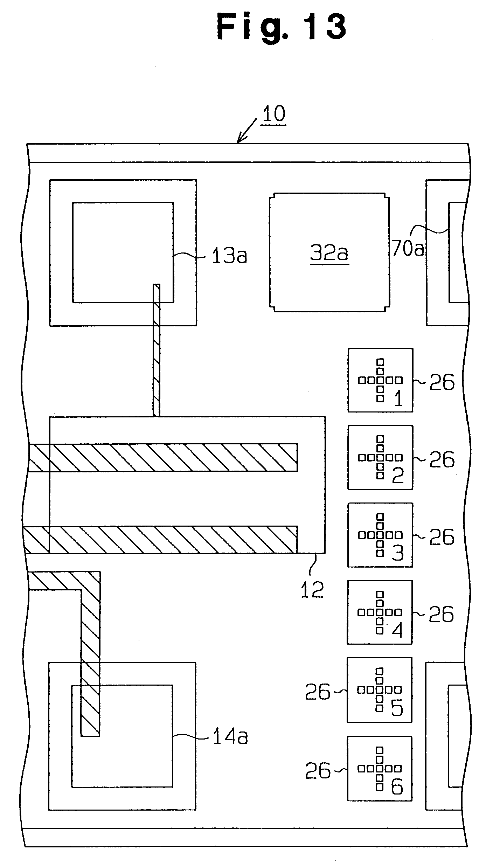

As shown in Fig. 13, a marking pad 32 is adjacent to the pad 70a. This pattern 32 is formed of aluminum in an approximately square shape with sides measuring about 100 micrometers. Six mask positioning patterns 26 are arranged in line below the marking pad 32. Each of the mask positioning patterns 26 is square in shape with sides measuring about 60 micrometers. The number of the patterns 26 corresponds to the number of photomasks to be used in the fabrication process (i.e., six masks in this case).

The design of a PLL synthesizer according to this embodiment, utilizes a layout much move efficient than conventional synthesizers due to the reduction in the size of the semiconductor substrate 10. This reduction results in increased semiconductor device yields and reduced semiconductor device production and manufacturing costs.

Positioning the pattern area 18 between the prescaler 11 and the amplifying circuit 15 prevents switching noise generated in the prescaler 11 from affecting the amplifying circuit 15. As previously described, the pattern area 18 can separate the analog circuit from the digital circuit by a predetermined distance. According to the present invention, this distance is preferably set in the range from 100 to 500 micrometers.

Although only two embodiments of the present invention have been described herein, it should be apparent to those skilled in the art that the present invention may be embodied in other specific forms. In particular, the above described embodiment may be modified as follows.

In the above embodiment, the reference frequency divider 47, the comparator/frequency divider 53, the phase comparator 48 and the charge pump 49, beside the prescaler 11, may be laid out as circuit elements of a digital circuit section on the substrate 10. Similarly, the reference oscillator 46, the LPF 50, the VCO 51 and the mixer 52, beside the amplifying circuit 15, may be laid out as circuit elements of a analog circuit section on the substrate 10.

In this specification, "analog circuit" means a circuit which processes time based consecutive linear values, and includes not only an amplifier, such as a differential amplifier or an operation amplifier, but also a modulator and a demodulator. "Digital circuit" as used in this specification means a circuit which processes a digital signal representative of the values "0" and "1", and includes a logic circuit, an operation circuit and a flip-flop.

The present examples and embodiments are to be considered as illustrative and not restrictive. For example, it is not excluded that the analog circuit section could include some digital circuit elements, or that the digital circuit section could include some analog circuit elements.

## Claims

1. A semiconductor device having a digital circuit section (2) and an analog circuit section (3) provided on a semiconductor substrate (1), said semiconductor device comprising:
a pattern area (4) provided between said digital and analog circuit sections (2, 3) separating the circuit sections by a predetermined distance, said pattern area (4) being provided with a plurality of patterns used in the fabrication of said semiconductor device, said pattern area (4) further being electrically insulated from said digital and analog circuit sections (2, 3).

2. The semiconductor device according to Claim 1, wherein said semiconductor device is a PLL synthesizer, said digital circuit section is a prescaler (11) and said analog circuit section is an amplifier circuit (15).

3. The semiconductor device according to Claim 2, wherein said digital circuit section includes a phase comparator (48) and a charge pump (49), and wherein said analog circuit section includes a mixer (52), and a voltage-controlled oscillator (51) for generating an oscillation signal.

4. The semiconductor device according to any one of Claims 1 to 3, wherein a device-characteristic monitoring element (18a) is formed in said pattern area.

5. The semiconductor device according to any one of Claims 1 to 4, wherein a ring oscillator (25) is formed in said pattern area, for evaluation of the device performance during the manufacture of said semiconductor device.

6. The semiconductor device according to any one of Claims 1 to 5 , wherein a mask positioning pattern (26) is formed in said pattern area.

7. The semiconductor device according to any one of Claims 1 to 6 , wherein an etch monitoring pattern (27) is formed in said pattern area.

8. The semiconductor device according to any one of Claims 1 to 7 , wherein a size measuring pattern (30) is formed in said pattern area.

9. The semiconductor device according to any one of Claims 1 to 8 , wherein a probing test pad (23) is formed in said pattern area.

10. The semiconductor device according to any one of Claims 1 to 9 , wherein a marking pad (32) is formed in said pattern area.

11. The semiconductor device according to any one of Claims 1 to 10, wherein a mask identifying character pattern (33) is formed in said pattern area.

12. The semiconductor device according to Claim 6, wherein said mask positioning pattern is located substantially in the center of the semiconductor substrate.
